(19) Europäisches Patentamt
European Patent Office
Office européen des brevets

(11) Publication number: **0 024 894**
**A1**

(12) # EUROPEAN PATENT APPLICATION

(21) Application number: 80302907.3

(22) Date of filing: 21.08.80

(51) Int. Cl.³: H 03 K 13/25
G 11 C 8/00

(30) Priority: 22.08.79 JP 106902/79

(43) Date of publication of application: 11.03.81 Bulletin 81/10

(84) Designated Contracting States: DE FR GB NL

(71) Applicant: FUJITSU LIMITED
1015, Kamikodanaka Nakahara-ku
Kawasaki-shi Kanagawa 211(JP)

(72) Inventor: Isogai, Hideaki
4-11-13, Minamisawa Higashikurume-shi
Tokyo 180-03(JP)

(74) Representative: Abbott, Leonard Charles et al,
GILL JENNINGS & EVERY 53/64 Chancery Lane
London WC2A 1HN(GB)

(54) **Decoder circuit.**

(57) A decoder circuit for a semiconductor memory device includes input terminal gates ($G_{00}$-$G_{03}$) which receive address signal bits; first decoder lines (DL1) for decoding output signals of some of the input terminal gates, and multi-emitter transistors (Ga-Gd, $Q_7$) each having emitter terminals connected to the first decoder lines and a collector terminal connected to a power source and to the base of a transistor (Ga-Gd,$Q_7$) which drives one of a plurality of groups of output terminal gates ($G_{10}$-$G_{25}$), the multi-emitter transistors turning the driving transistor on or off depending upon the potential of the first decoder lines. Second decoder lines ($DL_{II}$) are provided for decoding output signals from the remainder ($G_{02}$,$G_{03}$) of the input terminal gates. Further multi-emitter transistors ($G_{10}$-$G_{25}$,$Q_7$) have their emitter terminals connected to the second decoder lines, and each has a collector terminal connected via a resistor to the emitter of the associated transistor (Ga-Gd,$Q_7$) for driving the group of output terminal gates and to the base of an output transistor ($G_{10}$-$G_{25}$,$Q_7$), the multi-emitter transistors turning the output transistor on or off depending upon the potential of the second decoder lines and upon the emitter potential of the transistor (Ga-Gd,$Q_7$) which drives the group of the output terminal gates. Diode matrices can be used in place of multi-emitter transistors. In the present invention, constant current sources ($I_1$) are connected to the second decoder lines and emitter-follower transistors ($Q_8$-$Q_9$) are inserted between the power source and the second decoder lines and are turned on or off by the output signals of the said remainder of the input terminal gates.

EP 0 024 894 A1

./...

*Fig. 7*

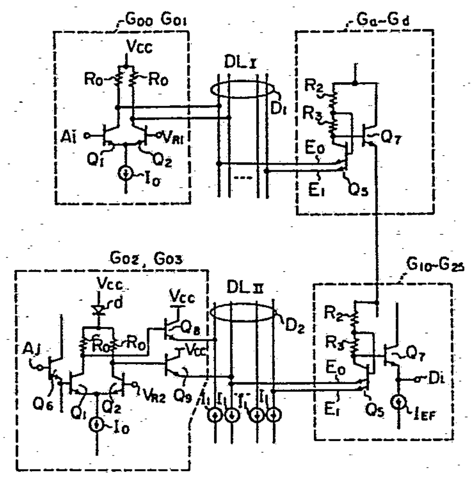

G00 G01
Vcc
R0
R0
Ai
VR1
Q1
Q2
I0
DL I
D1
Ga-Gd
R2
R3
Q7
E0
E1
Q5
G02, G03
Vcc
rd
R0
R0
Vcc
Q8
Vcc
Aj
Q6
Q1
Q2
VR2
Q9
I0
DL II
D2
I1
G10-G25
R2
R3
Q7
E0
Di
E1
Q5
IEF

# DECODER CIRCUIT

The present invention relates to a decoder circuit, e.g. for a semiconductor memory device, which is so constructed as to attain the requirements of low power consumption and high-speed operation.

Japanese Patent Application No.50-84820 (Japanese Patent Laid-Open No.52-8739) discloses a system which utilizes an emitter coupled logic (ECL) and a diode (or a multi-emitter) matrix, and which selects or does not select the diode matrix in a two-dimensional manner or higher dimensional manner, in order to reduce the consumption of electric power and to reduce the number of elements in the decoder circuit.

The decoder circuit mentioned above is advantageous with regard to reduced power consumption and reduced number of elements as compared with the conventional decoder circuits, but presents the defect that the output level rises and falls slowly, since the decoder lines are very lengthy as they run over the groups of memory cells and, hence, possess a large capacitance. Therefore, when the reading level is higher than the point at which the fall in the rate of rise of the output waveform takes place, the access time tends to be delayed.

An object of the present invention is to increase the rate of rise of the output waveform of a decoder circuit.

A decoder circuit according to the present invention comprises a plurality of input terminal gates which receive address signal bits; first decoder lines for decoding the output signals from some of the input terminal gates; diode matrices or multi-emitter transistors having terminals selectively connected to the first decoder lines, and having other terminals connected via resistors to a power source and to the bases of transistors for driving respective groups of output terminal gates, the diode matrices or the multi-emitter transistors being capable of turning the said driving transistors on or off depending upon the potentials of the first decoder lines; second decoder lines for decoding the output signals from the remainder of the input terminal gates; further diode matrices or multi-emitter transistors having terminals selectively connected to the second decoder lines, and hvaing other terminals connected via resistors to the emitters of the transistors for driving the groups of output terminal gates and to the bases of output transistors, the further diode matrices or the multi-emitter transistors being capable of turning the output transistors on or off depending upon the potentials of the second decoder lines and upon the emitter potentials of the transistors which drive the groups of output terminal gates, and characterized in that constant current sources are connected to the second decoder lines and in that emitter follower-connected transistors are inserted between the power source and the second decoder lines, and are turned on or off by the output signals of the said remainder of the input terminal gates.

Further features and advantages of the present invention will be apparent from the ensuing description of an example of a circuit embodying the invention with reference to the accompanying drawings in which:-

Figure 1 is a block diagram of a memory device;

Figure 2 is a block diagram of a decoder used in the memory device illustrated in Figure 1;

Figure 3A is a circuit diagram of the decoder constructed to deal with addresses consisting of four bits;

Figure 3B, 3C, 3D and 3E are diagrams of conventional circuits used in the matrix-type decoder illustrated in Fig. 3A;

Fig. 4 illustrates a portion of a decoder circuit of Fig. 3A using the conventional circuits of Figs. 3B, 3C and 3E;

Fig. 5 illustrates a portion of a decoder circuit of Fig. 3A, using the conventional circuits of Figs. 3B, 3C and 3D;

Fig. 6 is a diagram illustrating the waveform of the conventional decoder circuit;

Fig. 7 is a circuit illustrating the decoder according to one embodiment of the present invention, and;

Fig. 8 is a diagram illustrating the output waveform of the decoder circuit according to the present invention.

Fig. 1 illustrates a construction of integrated circuit memory device. Referring to Fig. 1, a decoder (X) 1 and a decoder (Y) 2 are connected to a cell array 3. The decoder (X) 1 and the decoder (Y) 2 receive address signals $A_0 \ldots A_{n-1}$ and $A_n \ldots A_{n+m-1}$, respectively, and the cells arranged in matrix form are selected by the outputs of the decoder (X) 1 and the decoder (Y) 2. A presense amplifier 4 writes or reads the information from or into the cell selected from the outputs of the decoder (X) 1 and the decoder (Y) 2. The read data are amplified by the sense amplifier 5. A hold current source 6 is provided for holding the information in the memory cell in the cell array 3.

In the block diagram of Fig. 1, the output waveforms of the decoder circuit (X) 1 rise slowly. The object of the present invention is to improve the output waveform of the decoder circuit (X). Therefore, the present invention will be explained with respect to the problem caused in the decoder circuit (X) 1. Hereinafter, the decoder circuit (X) 1 is called the decoder circuit.

Fig. 2 is a block diagram of a decoder of the above--mentioned matrix system, and Fig. 3A is a circuit diagram when the address consists of four bits. Referring to Fig. 2., gate circuits $G_{00}$ to $G_{0n}$ of the first stage are divided into two groups, i.e., $G_{00}$ to $G_{0i}$ and $G_{0j}$ to $G_{0n-1}$ which correspond to a plurality of upper bits and a plurality of lower bits of the input signals. Gate circuits $G_{10}$ to $G_{rs}$ of the second stage are also divided into a plurality of groups GI to GIV which correspond to the upper and lower bits. Binary signals consisting of n bits are divided into upper digits 0 to i, and lower digits j to n-1. The former digits are fed to the upper gate circuits $G_{00}$ to $G_{0i}$ of the first stage so that their outputs will select the gate circuits of the groups GI to GIV of the second stage, and the latter digits are fed to the lower gate circuits $G_{0j}$ to $G_{0n-1}$ of the first stage so that their outputs are fed in parallel as decoding input signals to each of the gate circuits GI to GIV of the second stage, whereby any one of the gate circuits of the second stage is allowed to produce an output.

Fig. 3A illustrates a decoder circuit which is so constructed as to deal with binary input signals each consisting of four bits, in which symbols $G_{00}$, $G_{01}$, and $G_{02}$, $G_{03}$ denote four gate circuits of the first stage. The gate circuits of the former group form a differential amplifier circuit as illustrated in Fig. 3B, and the gate circuits of the latter group form a differential amplifier circuit as illustrated in Fig. 3C. The circuit illustrated in Fig. 3C has a transistor $Q_6$ which functions as an emitter follower in the input stage, and has load resistors $R_0$ which are connected to a power source $V_{CC}$ via a diode d. Symbols GI to GIV denote four groups of second-stage gate circuits, each group consisting of four second-stage gate circuits $G_{10}$ to $G_{13}$, $G_{14}$ to $G_{17}$, $G_{18}$ to $G_{21}$, and $G_{22}$ to $G_{25}$. The second-stage gate circuits $G_{10}$ to $G_{25}$ consist of a diode matrix or a multi-transistor circuit as illustrated in Fig. 3D or Fig. 3E, and have an emitter follower which consists of a transistor $Q_7$ on the output side. Symbols Ga to Gd denote decoders which receive binary output signals, each consisting of two bits from the upper first-stage gate circuits $G_{00}$ and $G_{01}$, and which energize any one of the four second-stage gate circuit groups GI to GIV. The decoders Ga to Gd are constructed in the same manner and have the same function as the second-stage gate circuit groups GI to GIV.

A portion of the decoder circuit of Fig. 3A is shown in Fig. 4 relying upon the circuits of Figs. 3B, 3C and 3E, and a portion of the decoder circuit of Fig. 3A is shown in Fig. 5 replying upon the circuits of Fig. 3B, 3C and 3D.

Next, the operation of the conventional decoder circuit will be explained with reference to the circuit illustrated in Fig. 5. Referring to Fig. 5, it is assumed that the input signals $A_0$, $A_1$, $A_2$ and $A_3$ have L, H, L, L levels, respectively, where L denotes a low level and H denotes a high level. Logically, these input signals correspond to the values 0, 1, 0, 0, respectively. In these input signals, the upper two bits 01 are supplied to the first gate circuits $G_{00}$ and $G_{01}$, so that the transistors $Q_{2a}$ and $Q_{1b}$ are placed in an on state. Accordingly, in the decoder circuits $G_a$, $G_b$, $G_c$ and $G_d$, the diodes $d_{10}$, $d_{21}$, $d_{30}$ and $d_{31}$ are placed in an on state, so that the decoder circuits $G_a$ only generates an output having a high level. The outputs $V_{B0}$, $V_{B1}$, $V_{B2}$ and $V_{B3}$ of the decoder circuits are supplied to the electric source terminals $V_G$ of the second stage decoder circuits GI ∿ GIV, and only the decoder circuit GI is placed in an operative condition and the other decoder circuits GII ∿ GIV are placed in non operative condition. Thus, the second stage decoder circuit GI is selected by the upper two bits of the input signal.

The lower two bits of the input signal are supplied to the gate circuits $G_{02}$ and $G_{03}$, so that the transistors $Q_{2c}$ and $Q_{2d}$ are placed in the on state. Accordingly, the diodes $d'_{11}$, $d'_{21}$, $d'_{30}$ and $d'_{31}$ in the gate circuit GI are placed in the on state, so that only the output $D_{10}$ is

placed in the high level.

When the input signals $A_0 \sim A_3$ have another combination of H and L, similar to the above-mentioned operation anyone of the outputs $D_{10} \sim D_{25}$ of the second gate circuits GI ∿ GIV is placed in the high level state, so that 16 pieces of information included in four bits binary signal can be decoded.

A decoder circuit having a matrix type as mentioned above, is advantageous with regard to reduced power consumption and reduced number of elements as compared to the conventional decoder circuits, but presents the defect that the output level rises slowly. Fig. 6 illustrates the output waveform of the above-mentioned decoder circuit. When the output rises from the low level to the high level, it should ideally rise as indicated by a dotted line. In practice, however, the output assumes a waveform as indicated by a solid line. Therefore, when the reading level is higher than a certain value, the access time tends to be delayed. That is, in the conventional circuits, the output level rises slowly, since the decoder lines DLII are very lengthy as they run over the groups of memory cells and, hence, possess a large capacitance C. The level in the decoder lines $D_2$ is raised when they are electrically charged by the power source $V_{CC}$ through resistors $R_0$ in the input terminal gates $G_{02}$ , $G_{03}$. Therefore, the level in the decoder lines DLII rises slowly due to a time constant $R_0C$.

With reference to the matrix decoder circuit, furthermore, the potential in the output terminals $G_{10} \sim G_{25}$ should be at a low level when they are not selected, however, the potential in these output terminals tends to be slightly raised at the moment when the address is being switched. Therefore, the level of the decoder lines DLII rises slowly.

The invention is illustrated below with reference to an embodiment. Fig. 7 illustrates a decoder circuit according to an embodiment of the present invention, in which the same symbols as those of Figs. 2 to 5 denote the same members. Symbols DLI and DLII denote decoder lines, $I_1$ denote constant current sources, and $Q_8$ and $Q_9$ denote transistors which are connected in an emitter follower manner. The circuit of Fig. 7 is different from the conventional circuits in that the outputs of the first-stage gate circuits $G_{02}$ , $G_{03}$ are connected to the decoder lines DLII via emitter-follower transistors $Q_8$ , $Q_9$ , and that constant current sources I are connected to the decoder lines DLII. The decoding operation is carried out in the same manner as that of the conventional circuits. With reference to the circuit of Fig. 7 of the present invention, the level of the decoder lines DLII is raised through the emitter-follower transistors $Q_8$ , $Q_9$ in the input terminal gates $G_{02}$ , $G_{03}$. Therefore, a resistance component which affects the rise of the level of the decoder line DLII is very small and the level is allowed to rise very quickly.

Furthermore, the potential in the output terminals $G_{10} \sim G_{25}$ should be at the low level when they are not selected. This requirement can be satisfied by the circuit illustrated in Fig. 7. In addition, the circuit of the present invention enables the level of the decoder line DLII to be quickly raised.

Fig. 8 is a diagram illustrating the output waveform of the decoder circuit according to the present invention. The output waveform when it is raised from the low level to the high level, is deformed at a level which is higher than that of the conventional cicruits. Accordingly, the time until the reading level is reached, is not delayed.

According to the present invention, as illustrated in the foregoing, the matrix-type decoder circuit enables the output level to be raised without being delayed, and makes it possible to satisfy the requirements of high-speed operation and low power consumption.

CLAIM

A decoder circuit comprising: a plurality of input terminal gates ($G_{00}$-$G_{03}$) which receive address signal bits; first decoder lines ($DL_1$) for decoding the output signals from some of the input terminal gates ($G_{00}$,$G_{01}$); diode matrices or multi-emitter transistors (Ga-Gd, $Q_5$) having terminals selectively connected to the first decoder lines, and having other terminals connected via resistors to a power source and to the bases of transistors (Ga-Gd, $Q_7$) for driving respective groups of output terminal gates ($G_{10}$-$G_{25}$), the diode matrices or the multi-emitter transistors being capable of turning the said driving transistors on or off depending upon the potentials of the first decoder lines; second decoder lines ($DL_{II}$) decoding the output signals from the remainder of the input terminal gates ($G_{02}$,$G_{03}$); further diode matrices or multi-emitter transistors ($G_{10}$-$G_{25}$,$Q_5$) having terminals selectively connected to the second decoder lines ($DL_{II}$), and having other terminals connected via resistors to the emitters of the transistors (Ga-Gd,$Q_7$) for driving the groups of output terminal gates and to the bases of output transistors ($G_{10}$-$G_{25}$,$Q_7$), the further diode matrices or the multi-emitter transistors being capable of turning the output transistors on or off depending upon the potentials of the second decoder lines and upon the emitter potentials of the transistors which drive the groups of output terminal gates, and characterised in that constant current sources ($I_1$) are connected to the second decoder lines ($DL_{II}$) and in that emitter follower-connected transistors ($Q_8$,$Q_9$) are inserted between the power source ($V_{cc}$) and the second decoder lines, and are turned on or off by the output signals of the said remainder of the input terminal gates ($G_{02}$,$G_{03}$).

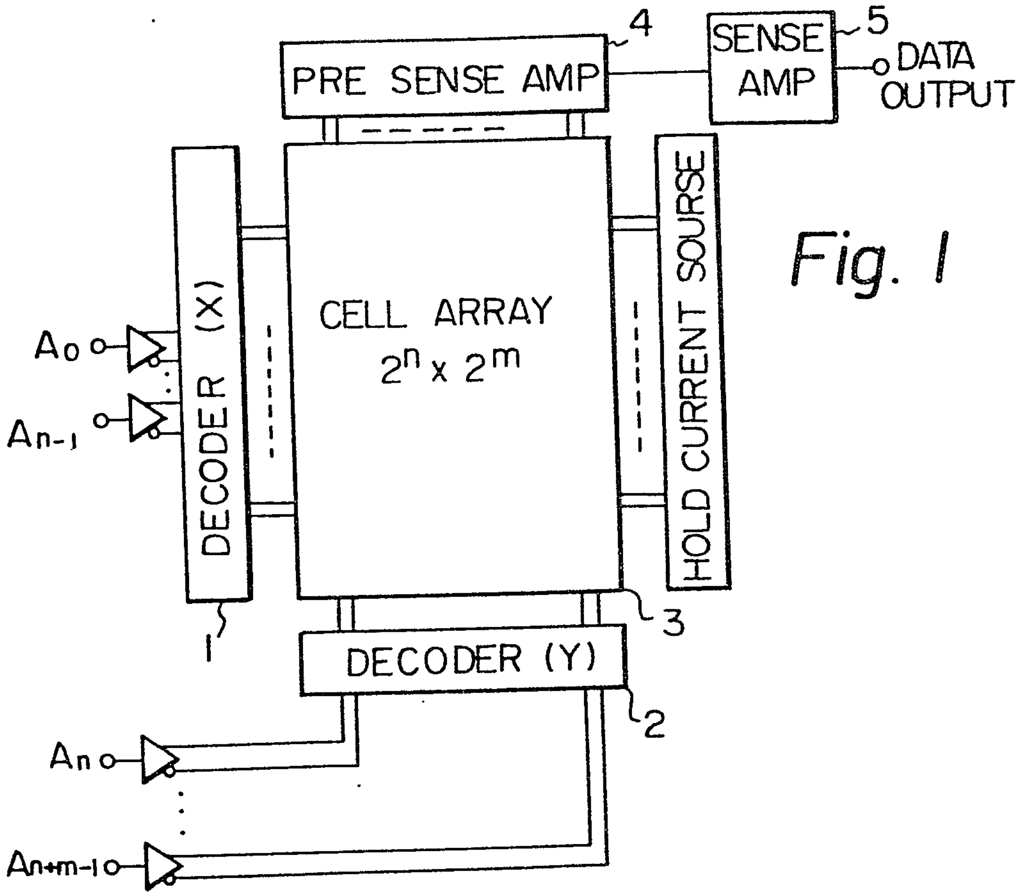
PRE SENSE AMP
4
SENSE AMP
5
DATA OUTPUT
DECODER (X)
CELL ARRAY
$2^n \times 2^m$
HOLD CURRENT SOURSE
A0
An-1
1
3
DECODER (Y)
2
An
An+m-1

Fig. 1

Fig. 2

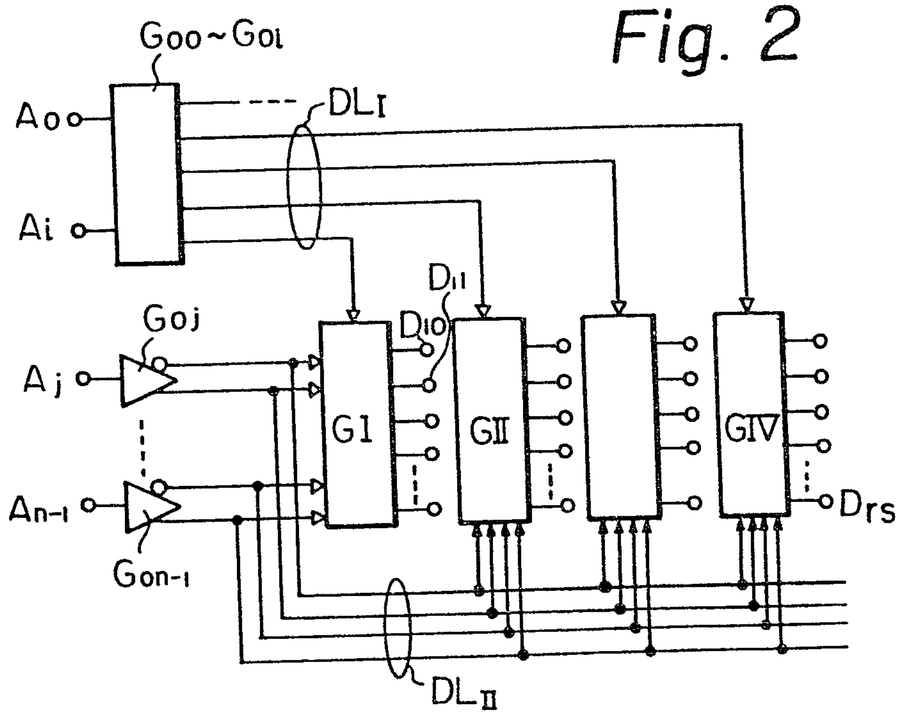
G00~G0l
A0
Ai
DLI
D11
D10
G0j
Aj
GI
GII
GIV
An-1
G0n-1
Drs
DLII

Fig. 3A

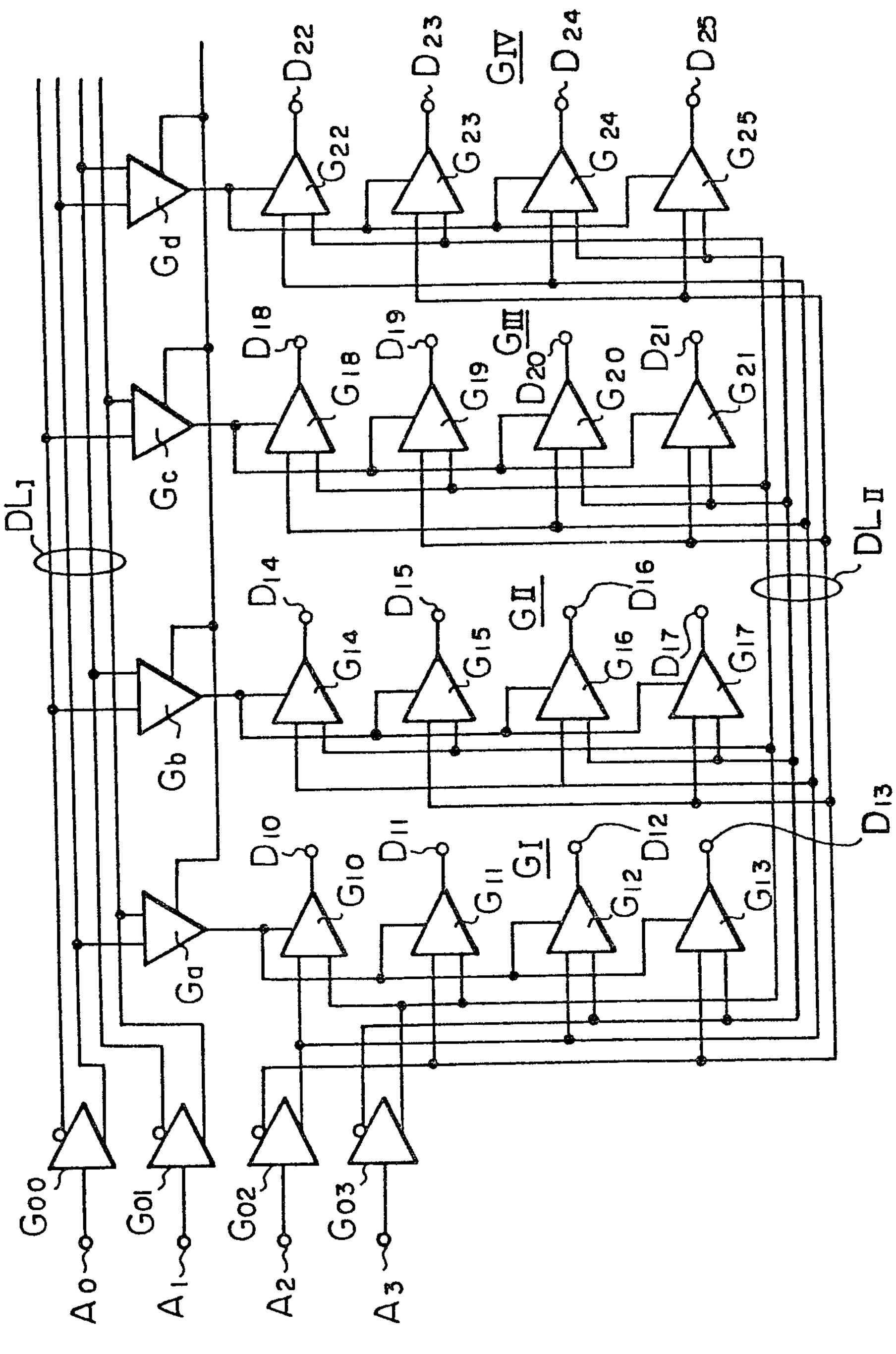
A0
A1
A2
A3
G00
G01
G02
G03
Ga
Gb
Gc
Gd
DL1
DLII
GI
GII
GIII
GIV
G10
G11
G12
G13
G14
G15
G16
G17
G18
G19
G20
G21
G22
G23
G24
G25
D10
D11
D12
D13
D14
D15
D16
D17
D18
D19
D20
D21
D22
D23
D24
D25

Fig. 3B

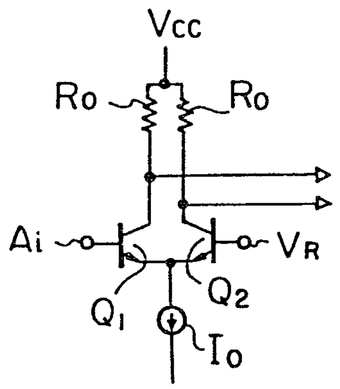


Fig. 3C

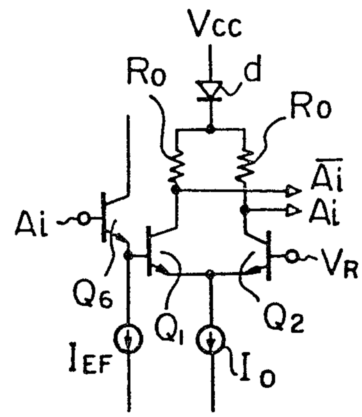


Fig. 3D

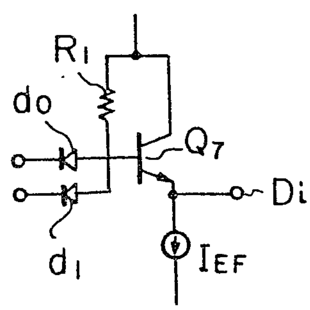


Fig. 3E

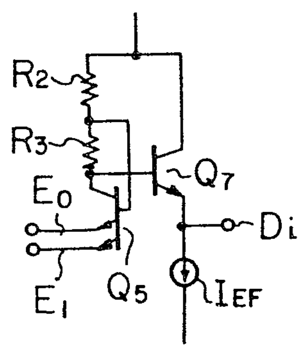

Fig. 4

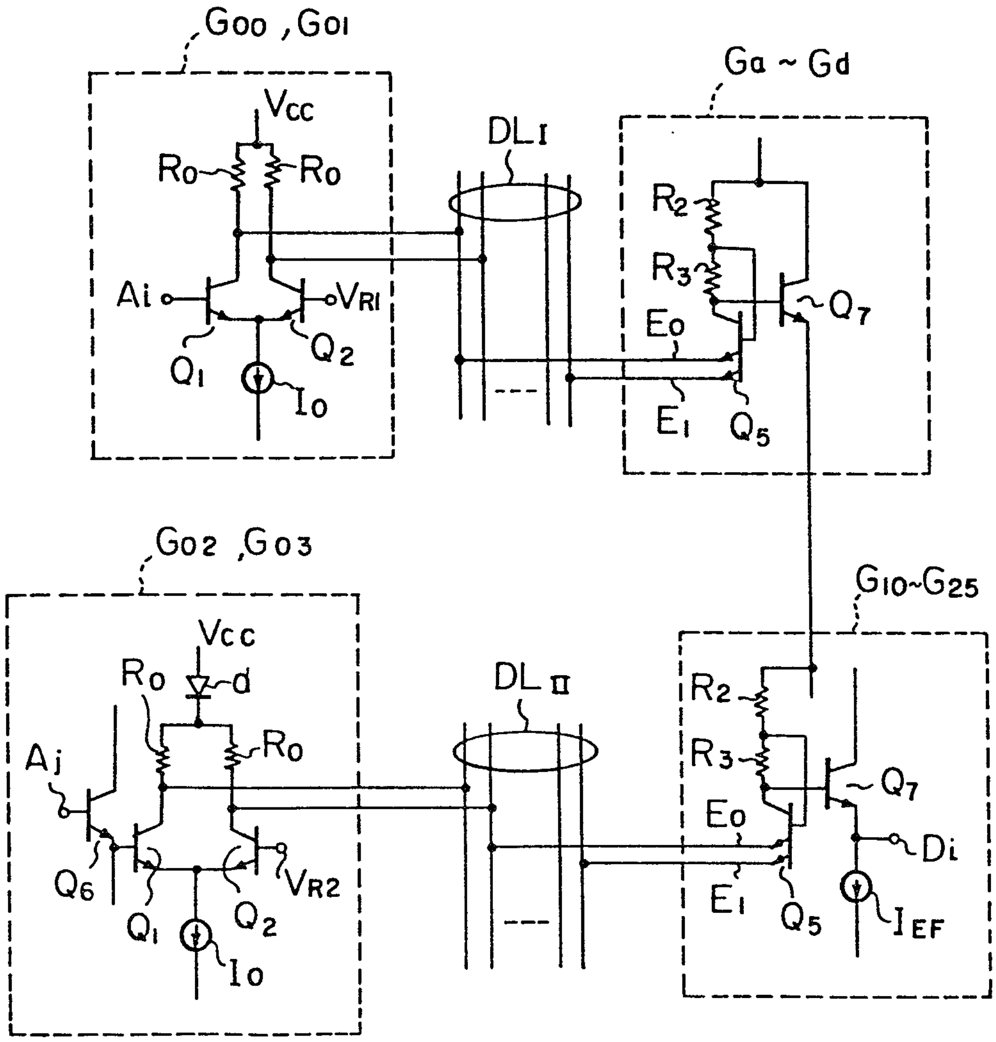
G00 ,G01
Vcc
R0
R0
DLI
Ga ~ Gd
R2
R3
Q7
Ai
VR1
Q1
Q2
I0
E0
E1
Q5
G02 ,G03
Vcc
R0
d
R0
DLII
G10~G25
R2
R3
Q7
Aj
Q6
Q1
Q2
VR2
I0
E0
E1
Q5
Di
IEF

Fig. 5

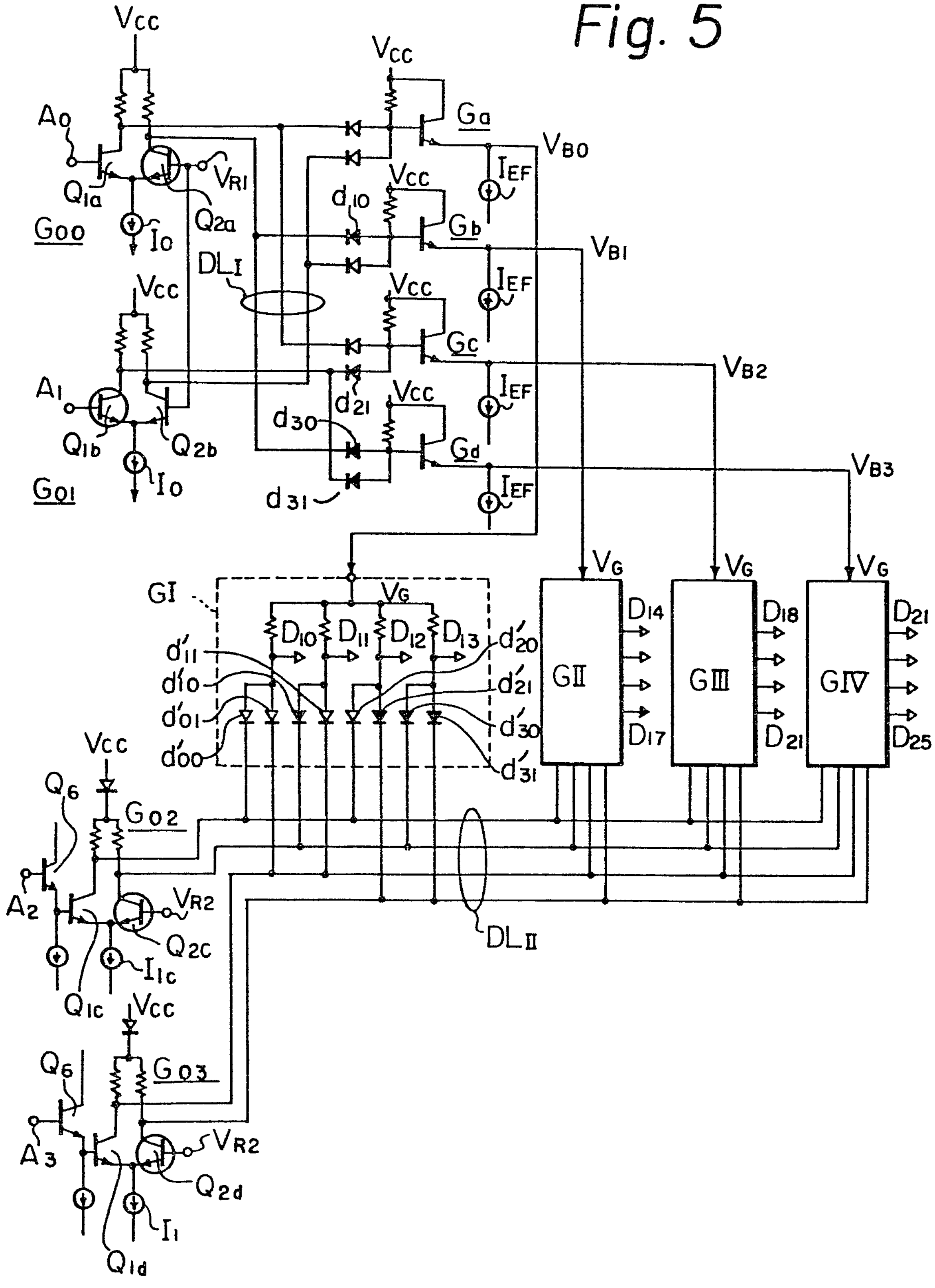
Vcc
A0
Q1a
Q2a
VR1
G00
I0
Ga
Gb
Gc
Gd
VB0
VB1
VB2
VB3
IEF
d10
d21
d30
d31
DLI
A1
Q1b
Q2b
G01
GI
VG
D10
D11
D12
D13
d'11
d'10
d'01
d'00
d'20
d'21
d'30
d'31
GII
GIII
GIV
D14
D17
D18
D21
D25
Q6
G02
A2
VR2
Q2c
Q1c
I1c
DLII
G03
A3
Q2d
Q1d
I1

Fig. 6

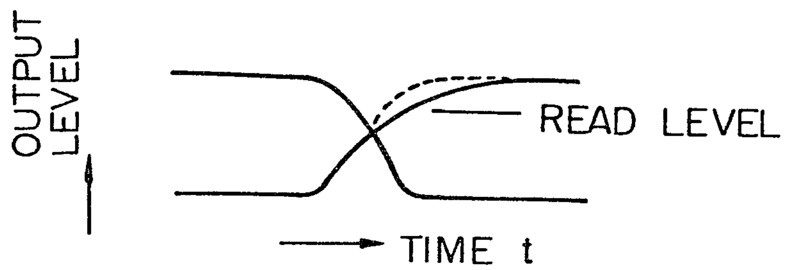
OUTPUT LEVEL
READ LEVEL
TIME t

Fig. 8

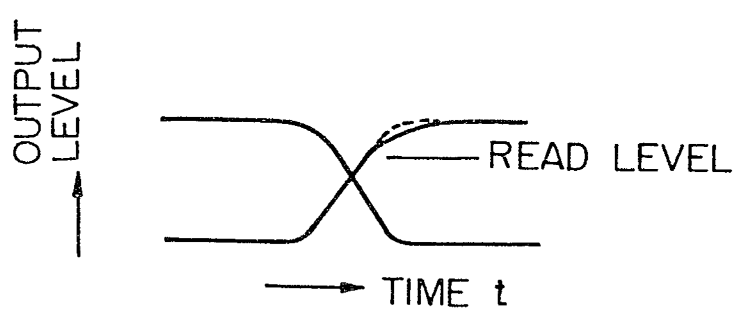
OUTPUT LEVEL
READ LEVEL
TIME t

# Fig. 7

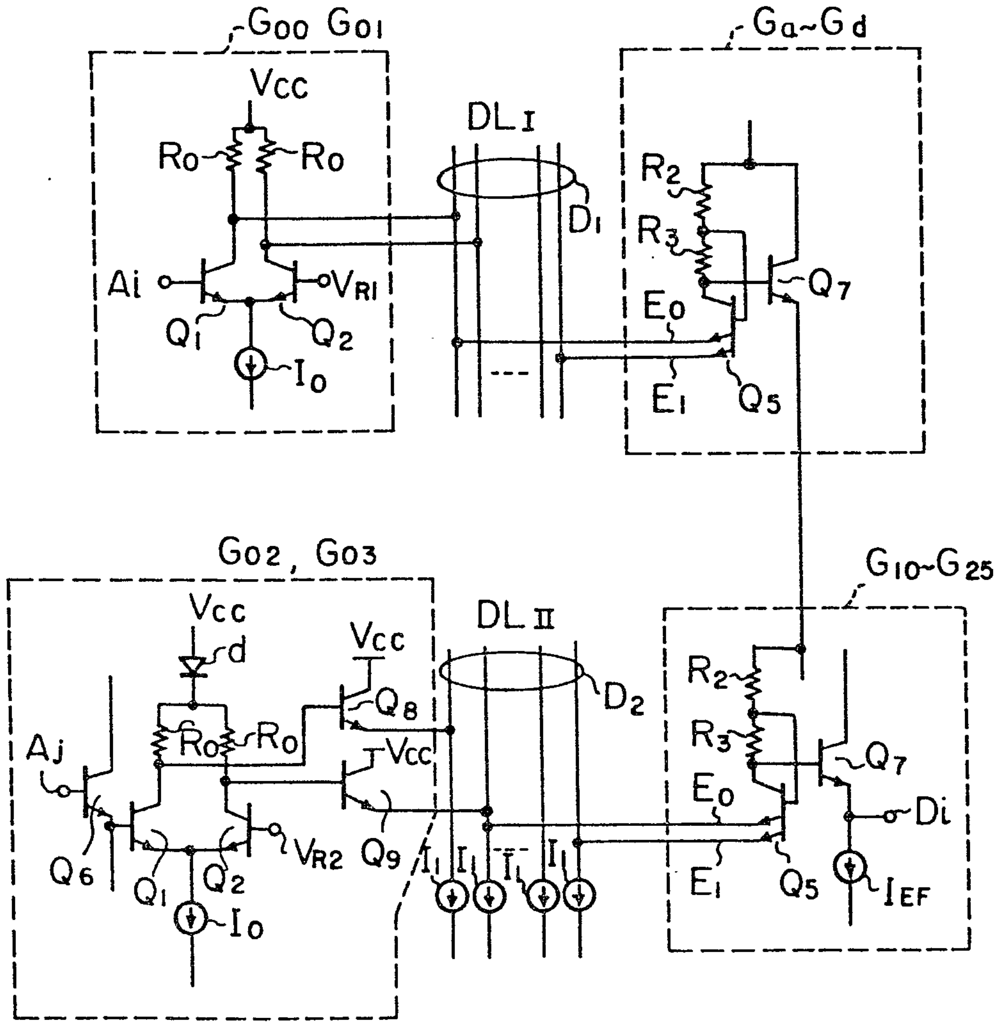
Goo Go1
Vcc
Ro
Ro
Ai
VR1
Q1
Q2
Io
DL I
D1
Ga~Gd
R2
R3
Q7
E0
E1
Q5
Go2, Go3
Vcc
d
Vcc
Q8
Ro
Ro
Vcc
Aj
Q6
Q1
Q2
VR2
Q9
Io
DL II
D2
I1
I1
I1
I1
G10~G25
R2
R3
Q7
E0
E1
Q5
Di
IEF

0024894

European Patent Office

# EUROPEAN SEARCH REPORT

Application number
EP 80 30 2907

| Category | Citation of document with indication, where appropriate, of relevant passages | Relevant to claim | CLASSIFICATION OF THE APPLICATION (Int. Cl.3) |
|---|---|---|---|
| | GB - A - 2 007 427 (SIEMENS)<br>* Page 1, line 93 - page 3, line 10; figures 1,2 *<br>-- | 1 | H 03 K 13/25<br>G 11 C 8/00 |
| | DE - A - 2 658 523 (SIEMENS)<br>* Page 7, line 6 - page 8, line 30; page 9, line 7 - page 12, line 25; page 14, line 23 - page 16, line 5; figures 1,2, 2A,2B,4 *<br>-- | 1 | |
| | IEEE ELECTRO 78 CONFERENCE RECORD, May 1978, paper 27/2, pages 1-14 New York, U.S.A.<br>J. STINEHELFER et al.: "Applications of Bipolar Isoplanar Memories"<br>* Page 5, right-hand column, line 15 - page 7, left-hand column, line 22; figures 11-14 *<br>-- | 1 | TECHNICAL FIELDS SEARCHED (Int. Cl.3)<br>G 11 C 8/00<br>11/40<br>H 03 K 13/243<br>13/25 |
| | IEEE INTERNATIONAL SOLID-STATE CIRCUITS CONFERENCE, 15th February 1979, pages 102,103<br>New York, U.S.A.<br>U. BUERKER et al.: "An ECL 100K Compatible 1024x4b RAM with 15ns Access Time"<br>* Page 102, right-hand column, lines 1-15; figures 1,2 *<br>-- | 1 | |
| | IEEE INTERNATIONAL SOLID STATE CIRCUITS CONFERENCE, 15th February 1979, pages 108,109<br>New York, U.S.A. ./. | 1 | CATEGORY OF CITED DOCUMENTS<br>X: particularly relevant<br>A: technological background<br>O: non-written disclosure<br>P: intermediate document<br>T: theory or principle underlying the invention<br>E: conflicting application<br>D: document cited in the application<br>L: citation for other reasons |
| X | The present search report has been drawn up for all claims | | &: member of the same patent family, corresponding document |

| Place of search | Date of completion of the search | Examiner |
|---|---|---|
| The Hague | 01-12-1980 | HARRIS |

European Patent Office

# EUROPEAN SEARCH REPORT

Application number
EP 80 30 2907



| Category | Citation of document with indication, where appropriate, of relevant passages | Relevant to claim | CLASSIFICATION OF THE APPLICATION (Int. Cl. 3) |
|---|---|---|---|
| | M. INADACHI et al.: "A 6ns 4Kb Bipolar RAM using Switched Load Resistor Memory Cell"<br>* Page 108, lines 27-35; figure 3 *<br>-- | | |
| A | IEEE TRANS. ON ELECTRON DEVICES, vol. ED-26, no. 6, June 1979, pages 886-892<br>New York, U.S.A.<br>K. KAWARADA et al.: "A 4K-bit Static $I^2L$ Memory"<br>* Page 889, left-hand column, line 16 - right-hand column, line 21; figure 6 *<br>-- | 1 | TECHNICAL FIELDS SEARCHED (Int. Cl. 3) |
| A | PATENTS ABSTRACTS OF JAPAN, vol. 1, no. 72, 13th July 1977, page 691E77<br>& JP - A - 52 8739 (TAKAHASHI)<br>---- | 1 | |